# EUROPÄISCHE PATENTSCHRIFT

(11) **EP 2 489 081 B1**
(45) Veröffentlichungstag und Bekanntmachung des Hinweises auf die Patenterteilung: **27.05.2015**
(21) Anmeldenummer: 10795196.4
(22) Anmeldetag: 12.10.2010
(51) Int. Cl.: H01L 41/047, H01L 41/09, H02N 2/00, H02N 2/02, H02N 2/10

(54) **AKTUATOR**
ACTUATOR
ACTIONNEUR

(30) Priorität: 17.10.2009 DE 102009049719
(43) Veröffentlichungstag der Anmeldung: 22.08.2012
(73) Patentinhaber: Physik Instrumente (PI) GmbH & Co. KG, 76228 Karlsruhe (DE)
(72) Erfinder: KOC, Burhanettin, 76275 Ettlingen (DE)
(74) Vertreter: Grünecker Patent- und Rechtsanwälte PartG mbB
(86) Internationale Anmeldenummer: PCT/DE2010/001195
(87) Internationale Veröffentlichungsnummer: WO 2011/044883

(56) Entgegenhaltungen:
- DE-A1- 10 154 168
- DE-A1-102007 015 057
- US-A- 3 721 841
- US-A1- 2002 140 783

## Beschreibung

Die Erfindung betrifft einen Aktuator, gemäß dem Oberbegriff des unabhängigen Patentanspruchs 1. Ein derartiger Aktuator ist beispielsweise aus der US 2002/0140783 A1 oder US 5,814,919 bekannt.

Die DE 10 2007 015 057 A1 offenbart einen piezoelektrischen Schwinger mit einem piezoelektrischen Element. Dieses piezoelektrischen Element umfasst eine erste piezoelektrische Elementschicht, auf der eine zweigeteilte Deckelektrode ausgeformt ist; ein zweites piezoelektrisches Element, das unterhalb der ersten piezoelektrischen Elementschicht angeordnet ist und auf dem eine innere Masseelektrode ausgeformt ist; und ein drittes piezoelektrisches Element, das unterhalb der zweiten piezoelektrischen Elementschicht angeordnet ist, wobei das dritte piezoelektrische Element eine Innenelektrode aufweist, die in Bezug zu einer Stapelebene symmetrisch zu der Deckelektrode ist, und wobei eine Bodenelektrode in einer Ebene gegenüber der Ebene ausgebildet ist, in der die Innenelektrode ausgeformt ist. Eine Seitenelektrode, umfasst erste und zweite Seitenelektroden, um Elektrodenbahnen elektrisch miteinander zu verbinden, die diagonal zwischen den Elektrodenbahnen verlaufen, die in den ersten und dritten piezoelektrischen Elementschichten des piezoelektrischen Elements ausgebildet sind. Eine dritte Seitenelektrode verbindet die innere Masseelektrode der zweiten piezoelektrischen Elementschicht mit der Bodenelektrode der dritten piezoelektrischen Elementschicht elektrisch. Ein Kraftübertragungselement, das an einer Seite des piezoelektrischen Elements ausgeformt ist, überträgt eine durch das piezoelektrische Element erzeugte Schwingung nach aussen. Bei vielfältigen Anwendungen, beispielsweise in Mobiltelefonen oder sog. Smartphones, besteht das Bedürfnis, die entsprechenden Geräte immer kleiner bzw. flacher zu bauen. Demzufolge werden immer kleiner bzw. flacher bauende Komponenten für solche Geräte benötigt, die aus Fertigungs- und Montagegründen auch möglichst einfach aufgebaut sein sollten. Die EP 2 216 837 A1 beschreibt in diesem Zusammenhang einen einfach aufgebauten, nur sehr wenig Bauraum einnehmenden piezoelektrischen Motor mit einem flachen und plattenförmigen Aktuator, der beispielsweise für den Antrieb des Autofokus einer Mobiltelefon-Kamera verwendet werden kann. Der dort gezeigte Aktuator bzw. Motor erlaubt allerdings nur Bewegungen entlang einer Achse. In einigen Fällen ist es notwendig, dass der entsprechende Motor Bewegungen in zwei Achsrichtungen zulässt, bzw. dass der Motor eine rotatorische Antriebsbewegung erzeugt.

Daher ist es Aufgabe der Erfindung, einen Aktuator bereitzustellen, der klein bzw. flach baut und der in der Lage ist, bei relativ einfachem Aufbau Bewegungen in zwei Achsrichtungen zu realisieren und der darüber hinaus dazu fähig ist, eine rotatorische Antriebsbewegung zu erzeugen.

Diese Aufgabe wird erfindungsgemäß durch eine Aktuator mit den Merkmalen des unabhängigen Patentanspruchs 1 gelöst. Bevorzugte Weiterbildungen und Ausführungen sind in den abhängigen Patentansprüchen dargelegt.

Somit wird ein Aktuator geschaffen , der ein piezoelektrisches Material aufweist, und welcher in Form einer einschichtigen oder mehrschichtigen flachen Platte vorliegt, wobei zumindest bei einer Schicht sowohl auf deren Oberseite, als auch auf deren Unterseite jeweils zwei, voneinander durch einen Trennbereich beabstandete Elektroden gegenüberliegend angeordnet sind, und die beiden Elektroden der Oberseite versetzt zu den beiden Elektroden der Unterseite angeordnet sind.

Durch die beiden auf der Oberseite der Schicht gegenüberliegend angeordneten Elektroden sind bei entsprechender elektrischer Kontaktierung und Ansteuerung schwingende Deformationen des Aktuators in einer ersten Achsrichtung generierbar, wobei besagte schwingende Deformationen zum Antrieb eines anzutreibenden Elements in eben dieser ersten Achsrichtung genutzt werden können. Durch die gegenüber den Elektroden der Oberseite versetzt angeordneten Elektroden der Unterseite sind nun durch entsprechende elektrische Kontaktierung und Ansteuerung schwingende Deformationen des Aktuators in einer anderen, zweiten Achsrichtung generierbar. Auch diese schwingenden Deformationen können dazu genutzt werden, ein anzutreibendes Element zu bewegen, und zwar entlang dieser zweiten Achsrichtung.

Die elektrische Ansteuerung der Elektroden der Oberseite und der Unterseite erfolgt vorzugsweise dergestalt, dass der Aktuator zu Schwingungen - insbesondere im Ultraschallbereich - bei einer mechanischen Resonanzfrequenz angeregt wird. In besonders bevorzugter Weise wird der Aktuator unter Anregung der zweiten longitudinalen Resonanzfrequenz oder einem ganzzahligen Vielfachen der zweiten longitudinalen Resonanzfrequenz betrieben, wobei die Longitudinalrichtung jeweils die Richtung bezeichnet, entlang derer die jeweils gegenüberliegend angeordneten Elektroden von Ober- und Unterseite angeordnet bzw. ausgerichtet sind.

Durch Anregung der zweiten longitudinalen Resonanzfrequenz oder ganzzahliger Vielfacher hiervon ergeben sich schwingende Deformationen des Aktuators, die im Wesentlichen in der Ebene des Aktuators liegen. Um durch diese periodischen Deformationen oder Schwingungen des Aktuators in einer Longitudinalrichtung eine Antriebsbewegung eines anzutreibenden Elements zu erzeugen, ist es notwendig, dass die Deformationen eine ganz bestimmte zeitliche Abfolge aufweisen, die ihre Entsprechung in den elektrischen Ansteuersignalen findet. So muss während eines Antriebsbewegungsschrittes, bei welchem der mit dem anzutreibenden Element in Friktionskontakt befindliche Aktuator das anzutreibende Element mitnimmt, eine vergleichsweise langsame Deformation in Longitudinalrichtung erfolgen, damit kein relatives Gleiten zwischen Aktuator und anzutreibendem Element auftritt, d.h. es sollten Haftreibungsbedingungen zwischen Aktuator und anzutreibendem Element herrschen. Demgegenüber muss während eines Rückbewegungsschrittes, bei welchem der Aktuator eine Deformation in entgegengesetzter Richtung vollführt, eine vergleichsweise schnelle Deformation in Longitudinalrichtung erfolgen, so dass die Haftreibungsbedingungen verlassen werden und Gleitreibung eintritt. Damit kann ein relatives Gleiten des Aktuators zum anzutreibenden Element realisiert werden, und der Aktuator nimmt das anzutreibende Element während des Rückbewegungsschritts nicht mit. Es resultiert ein sog. Stick-Slip-Antrieb bzw. eine Stick-Slip-Bewegung.

Die elektrische Ansteuerung der Elektroden von Ober- und Unterseite kann zeitlich gesehen entweder vollkommen getrennt voneinander erfolgen, oder aber im Zusammenspiel und zeitlich aufeinander abgestimmt. Bei vollkommen getrennter Ansteuerung kann beispielsweise zunächst eine alleinige Ansteuerung der Elektroden der Oberseite erfolgen, so dass zum Beispiel eine Bewegung eines über den Aktuator anzutreibenden Elements in einer ersten Achsrichtung, beispielsweise der x-Richtung, erzeugt wird. Sobald die vorgegebene x-Position des anzutreibenden Elements erreicht ist, kann durch die nun alleinige Ansteuerung der Elektroden der Unterseite eine Bewegung des über den Aktuator anzutreibenden Elements in einer zweiten Achsrichtung, beispielsweise der y-Richtung, erzeugt werden.

Durch zeitlich aufeinander abgestimmte elektrische Ansteuerung - d.h. durch Realisierung eines Phasenversatzes oder Phasenunterschieds bezüglich der Ansteuersignale - der Elektroden von Ober- und Unterseite ist es möglich, Deformationen zu erzeugen, die in einer rotatorischen Antriebsbewegung resultieren. Ein beispielsweise in der Mitte des Aktuators angeordnetes Friktionselement, das zum Friktionskontakt mit einem anzutreibenden Element vorgesehen ist, kann durch zeitlich aufeinander abgestimmte elektrische Ansteuerung der Elektroden von Ober- und Unterseite eine Kreis-Bewegung vollführen, und somit das anzutreibende Element durch Mitnahme in eine Rotationsbewegung versetzen.

Bevorzugte Ausgestaltungen des erfindungsgemäßen Aktuators sind Gegenstand der Unteransprüche.

Es kann von Vorteil sein, dass der Aktuator die Form einer polygonalen Platte, vorzugsweise einer quadratischen Platte aufweist. Weiterhin ist denkbar, dass der Aktuator die Form einer runden Platte, vorzugsweise einer kreisförmigen Platte, oder aber die Geometrie einer ringförmigen Platte aufweist.

Derartige Ausgestaltungen des Aktuators erweitern die konstruktiven Möglichkeiten und erlauben beispielsweise eine gezielte Anpassung an die geometrischen bzw. strukturellen Gegebenheiten, in denen der Aktuator zur Anwendung kommt bzw. in denen der Aktuator Verwendung findet.

Ebenso kann es von Vorteil sein, dass die Elektroden der Oberseite um im Wesentlichen 90° versetzt zu den Elektroden der Unterseite angeordnet sind.

Eine derartige Ausgestaltung bezüglich der Anordnung der Elektroden resultiert in einer besonders effektiven und wirkungsvollen Art des Antriebes. Hierbei kann es günstig sein, dass die Elektroden der Oberseite und/oder die Elektroden der Unterseite spiegelbildlich zueinander angeordnet sind.

Der Trennbereich ist im Wesentlichen linienförmig. Dies ermöglicht die Realisierung relativ großflächiger Elektrodenbereiche und ist außerdem fertigungstechnisch vergleichweise einfach ausführbar. Der Aktuator weist wenigstens ein Friktionselement auf, wobei das Friktionselement entlang des linienförmigen Trennbereichs, bevorzugt in dessen Mitte oder an einem Ende davon, angeordnet ist.

In der Mitte des linienförmigen Trennbereichs meint dabei in der Mitte bezüglich der Längsausdehnung des Trennbereichs. Es kann jedoch auch günstig sein, beispielsweise zwei voneinander beabstandete und - bezogen auf die Mitte hinsichtlich der Längsausdehnung des Trennbereichs - außermittig angeordnete Friktionselemente entlang des linienförmigen Trennbereichs vorzusehen. Durch Erhöhung der Anzahl an Friktionselementen ist eine höhere Antriebskraft erreichbar.

Außerdem kann es von Vorteil sein, dass das Friktionselement in den Aktuator, vorzugsweise in ein in dem Aktuator vorgesehenes Durchgangsloch, eingesetzt ist.

Derartige Ausgestaltungen betreffend die Anordnung des Friktionselements erlauben eine gezielte Anpassung an die Gegebenheiten, unter denen der Aktuator einsetzbar ist. Im Falle, dass der Aktuator als polygonale Platte und vorzugsweise als quadratische Platte ausgeführt ist, ist die Platzierung des Friktionselements, beispielsweise in Form einer Kugel oder einer Halbkugel, in der Mitte des linienförmigen Trennbereichs vorteilhaft, da hier in der Regel die höchsten Deformationen auftreten. In der Mitte des linienförmigen Trennbereichs meint dabei in der Mitte bezüglich der Längsausdehnung des Trennbereichs. Es kann jedoch auch günstig sein, beispielsweise zwei voneinander beabstandete und - bezogen auf die Mitte hinsichtlich der Längsausdehnung des Trennbereichs - außermittig angeordnete Friktionselemente entlang des linienförmigen Trennbereichs vorzusehen. Durch Erhöhung der Anzahl an Friktionselementen ist eine höhere Antriebskraft erreichbar. Günstigerweise weist das Friktionselement hierbei ein Material einer Hartkeramik wie Aluminiumoxid (Al₂O₃) oder Siliziumnitrid (Si₃N₄), oder ein Material einer Hart-Metall-Legierung oder eines Karbids wie Wolframkarbid auf und besteht vorzugsweise aus einem dieser Materialien.

In beiden Fällen, also bei Verwendung eines Friktionselements oder bei Verwendung von zwei (oder mehreren) Friktionselementen können diese beispielsweise kugelförmig sein und in ein jeweiliges Durchgangsloch des Aktuators, das von der Oberseite bis zur Unterseite reicht, eingesetzt sein und in dem Durchgangsloch mit Hilfe eines Klebstoffs, z.B. Epoxidharz, fixiert bzw. befestigt sein. Diese Art der Anbringung des Friktionselements bzw. der Friktionselemente bietet deutliche Vorteile für die Fertigung. So kann insbesondere in einer automatisierten Fertigung das kugelförmige Friktionselement einfach in das Durchgangsloch eingesetzt werden, wobei von den Dimensionen her das Friktionselement so ausgelegt ist, dass sein Radius geringfügig kleiner als der Radius des Durchgangsloches ist. Dadurch "fällt" das Friktionselement quasi in das Durchgangsloch, wird jedoch am Durchfallen gehindert aufgrund eines normalerweise direkt hinter dem Aktuator angeordneten Strukturelements, beispielsweise dem Strukturelement eines Motors, in welchen der Aktuator eingebaut ist. Da sowohl die Höhe des Aktuators bekannt ist, als auch der Durchmesser des kugelförmigen Friktionselements, ist der aus dem Aktuator herausragende Teil des Friktionselementes genau bestimmt.

Eine andere Möglichkeit der Anbringung eines Friktionselements ist es, auf der Oberfläche des Aktuators einen Kugelabschnitt und bevorzugt eine Halbkugel anzubringen und diesen/diese vorzugsweise anzukleben.

Im Falle, dass der Aktuator die Form einer ringförmigen Platte aufweist, ist es vorteilhaft, dass das Friktionselement bzw. die Friktionselemente am Ende des linienförmigen Trennbereichs angeordnet ist bzw. sind. Diese Platzierung der Friktionselemente ist fertigungstechnisch vergleichsweise einfach durchführbar.

Es kann sich als günstig erweisen, wenn der Aktuator piezokeramisches Material aufweist. Besonders geeignet ist hierbei Blei-Zirkonium-Titanat (PZT). Piezokeramische Materialien weisen in der Regel einen hohen (inversen) Piezo-Effekt auf, d.h. bei gegebener elektrischer Spannung ergibt sich bei diesen Materialien eine hohe Ausdehnung bzw. Deformation.

Ebenso kann es sich als günstig erweisen, wenn der Aktuator mehrschichtig aufgebaut ist und eine ungerade Anzahl von Schichten aufweist, wobei die sich jeweils zugewandten Elektroden angrenzender Schichten die gleiche Orientierung aufweisen. Durch einen mehrschichtigen Aufbau kann der Aktuator mit entsprechend geringerer elektrischer Spannung angesteuert werden.

Weiterhin kann es sich als günstig erweisen, wenn die oberste Schicht und/oder die unterste Schicht des Aktuators als inaktive Schicht ausgeführt sind/ist. Dadurch resultiert ein besonders zuverlässiger Aufbau des Aktuators, wobei zudem die Integration des Aktuators in einen entsprechenden Motor aus Isolationsgründen vereinfacht wird.

Außerdem kann es sich als günstig erweisen, wenn die oberste Schicht und/oder die unterste Schicht mit Terminationselektroden versehen sind/ist. Hierdurch ist eine einfach zu realisierende elektrische Kontaktierung des Aktuators möglich.

Es kann von Vorteil sein, dass der Aktuator unter Anregung der zweiten Resonanzfrequenz oder einem ganzzahligen Vielfachen der zweiten longitudinalen Resonanzfrequenz betrieben wird. Dadurch resultieren Schwingungen bzw. schwingende Deformationen des Aktuators, die in besonders effektiver Weise zum Antrieb eines anzutreibenden Elements genutzt werden können.

Es ist von Vorteil, dass durch elektrisches Ansteuern der Elektroden der Oberseite schwingende Deformationen des Aktuators entlang einer ersten Achsrichtung erzielbar sind, die zum Antrieb eines mit dem Aktuator in Kontakt stehenden beweglichen Elements in der ersten Achsrichtung nutzbar sind. Ebenso ist es von Vorteil, dass durch elektrisches Ansteuern der Elektroden der Unterseite schwingende Deformationen des Aktuators entlang einer zweiten Achsrichtung erzielbar sind, die zum Antrieb eines mit dem Aktuator in Kontakt stehenden beweglichen Elements in der zweiten Achsrichtung nutzbar sind. Hierdurch sind unabhängige Bewegungen des Aktuators in zwei unterschiedlichen, vorzugsweise senkrecht zueinander angeordneten Achsrichtungen möglich, bzw. der Aktuator kann dazu genutzt werden, ein mit diesem in Friktionskontakt befindlichen beweglichen oder anzutreibenden Elements in zwei unterschiedlichen Achsrichtungen anzutreiben.

Außerdem kann es von Vorteil sein, dass durch phasenverschobenes elektrisches Ansteuern der Elektroden der Oberseite und der Elektroden der Unterseite Hula-Hoop-artige Deformationen erzielbar sind, die zum rotatorischen Antrieb eines mit dem Aktuator in Kontakt stehenden beweglichen Elements nutzbar sind. Beispielsweise können die Elektroden der Oberseite mit einem sinusförmigen Spannungssignal angesteuert werden, während gleichzeitig die Elektroden der Unterseite mit einem co-sinusförmigen Spannungssignal beaufschlagt werden. Es kommt somit zu Überlagerungen von Deformationen in zwei verschiedenen Achsrichtungen, wobei sich die Deformationen kreis- bzw. Hula-Hoop-mäßig ausbreiten bzw. fortpflanzen. Ein beispielsweise im Zentrum des Aktuators angeordnetes Friktionselement vollführt somit eine quasi kreisförmige Bewegung, die auf ein anzutreibendes Element durch Friktionskontakt übertragen werden kann.

Darüber hinaus kann es von Vorteil sein, dass der Aktuator einen Stick-Slip-Antrieb darstellt. Ein Stick-Slip- bzw. Haft-Gleit-Antrieb (auch Trägheitsantrieb) beinhaltet eine relativ langsame Haftphase, bei der statische Reibung zwischen Aktuator und anzutreibendem Element vorherrscht und die für den eigentlichen Antrieb sorgt, und eine Gleitphase mit dynamischer Reibung zwischen Aktuator und anzutreibendem Element, die durch ein schnelles Rückzugsmoment realisiert wird. Der Stick-Slip-Antrieb bzw. das langsame Vorbewegen und das schnelle Rückbewegen werden dabei durch entsprechende elektrische Ansteuerung der am Aktuator angebrachten Elektroden realisiert. Dies kann sowohl für lineare Bewegungen, als auch für rotatorische Bewegungen angewendet werden. Ein Stick-Slip-Antrieb ist vergleichsweise einfach aufgebaut und dementsprechend sowohl relativ einfach zu realisieren als auch zu montieren.

Zudem kann es von Vorteil sein, dass die durch das elektrische Ansteuern der Elektroden erzielten Deformationen in der Ebene des Aktuators liegen. Dies wirkt sich insbesondere günstig auf die tribologischen Eigenschaften des Tribokontaktes zwischen Aktuator und anzutreibendem Element und hierbei besonders auf einen niedrigen Verschleiß aus. Zudem ergibt sich hierdurch gegenüber Aktuatoren, bei denen das Friktionselement beispielsweise in eine elliptische Bewegung versetzt wird mit einer Bewegungskomponente in der dritten Dimension - also aus der Ebene des Aktuators heraus -, eine stabilere Performance.

Ein weiterer bevorzugter Aspekt der Erfindung betrifft einen Motor, umfassend den Aktuator nach einer der vorangegangenen vorteilhaften Ausführungen und ein durch den Aktuator anzutreibendes bewegliches Element.

Bevorzugte Weiterbildungen der Erfindungen ergeben sich durch Kombinationen der Unteransprüche oder Teilen davon.

### Kurze Beschreibung der Zeichnungen

Es zeigen in schematischer, nicht maßstabsgetreuer Weise:
- Fig. 1: Erfindungsgemäßer Aktuator in Form einer quadratischen Platte
- Fig. 2: Erfindungsgemäßer Aktuator in Form einer ringförmigen Platte
- Fig. 3: Darstellung der elektrischen Ansteuerung des Aktuators gemäß Fig. 1 zur Realisierung einer zweiachsigen linearen Bewegung
- Fig. 4: Darstellung der elektrischen Ansteuerung des Aktuators gemäß Fig. 2 zur Realisierung einer zweiachsigen linearen Bewegung
- Fig. 5: Darstellung der elektrischen Ansteuerung des Aktuators gemäß Fig. 1 zur Realisierung einer rotatorischen Bewegung
- Fig. 6: Darstellung der elektrischen Ansteuerung des Aktuators gemäß Fig. 2 zur Realisierung einer rotatorischen Bewegung
- Fig. 7: Darstellung von Deformationen des Aktuators nach Fig. 1 bei elektrischer Ansteuerung gemäß Fig. 5 mit Hilfe der Finite-Elemente-Methode
- Fig. 8: Darstellung von Deformationen des Aktuators nach Fig. 2 bei elektrischer Ansteuerung gemäß Fig. 4 und Fig. 6 mit Hilfe der Finite-Elemente-Methode
- Fig. 9: Darstellung eines erfindungsgemäßen Aktuators in Form einer quadratischen Platte, der in mehreren Schichten aufgebaut ist
- Fig. 10: Darstellung eines weiteren erfindungsgemäßen Aktuators in Form einer quadratischen Platte, der in mehreren Schichten aufgebaut ist
- Fig. 11: Darstellung eines erfindungsgemäßen Aktuators in Form einer ringförmigen Platte, der in mehreren Schichten aufgebaut ist
- Fig. 12: Darstellung eines Motors mit dem erfindungsgemäßen Aktuator gemäß Fig. 1

### Detaillierte Beschreibung der bevorzugten Ausführungsbeispiele

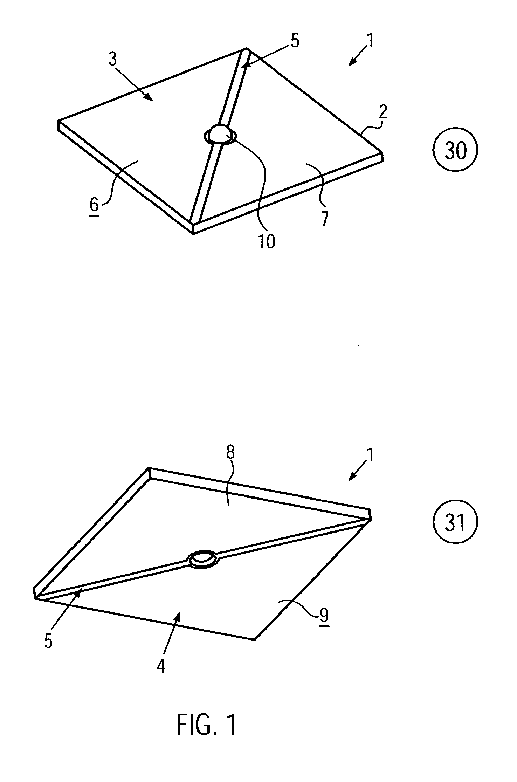

Figur 1 zeigt in schematischer Weise einen erfindungsgemäßen Aktuator 1 in Form einer quadratischen, einschichtigen Platte. Die obere Darstellung 30 zeigt in perspektivischer Ansicht den Aktuator von oben, d.h. mit Blickrichtung auf dessen Oberseite 3, während die untere Darstellung 31 den Aktuator von unten zeigt, d.h. mit Blickrichtung auf dessen Unterseite 4. Auf der Oberseite 3 sind zwei im Wesentlichen dreiecksförmige Elektroden 6 und 7 angeordnet, wobei sich zwischen den beiden Elektroden 6, 7 ein im Wesentlichen linienförmiger und unelektrodierter, d.h. keine Elektroden aufweisender Trennbereich 5 befindet, der sich von einer Ecke des Aktuators zur diagonal gegenüberliegenden Ecke erstreckt. Somit bildet besagter im Wesentlichen linienförmiger Trennbereich quasi eine Symmetrielinie, bezüglich derer die Elektroden 6 und 7 gespiegelt sind.

Die Elektroden 6, 7 erstrecken sich bis zu den entsprechenden Seitenflächen des Aktuators und schließen mit diesen ab. Genauso gut ist jedoch denkbar, dass die Elektroden zumindest abschnittsweise nicht ganz bis zu den Seitenflächen reichen, so dass ein entsprechender Bereich der Oberseite 3 zusätzlich zu dem Trennbereich 5 unelektrodiert ist. In Bezug auf die Längserstreckung des im Wesentlichen linienförmigen Trennbereichs 5 ist in dessen Mitte bzw. im Mittenbereich ein Friktionselement 10 angeordnet. Der Aktuator 1 weist hierzu ein entsprechendes Durchgangsloch auf, in welches das kugelförmige Friktionselement 10 eingesetzt bzw. eingebettet ist. Das Friktionselement 10 ist mittels eines Klebers, z.B. Epoxidharz, in dem Durchgangsloch befestigt. Ein definierter Teil des kugelförmigen Friktionselements 10 ragt über die Oberfläche des Aktuators an dessen Oberseite 3 heraus. Genauso gut kann das kugelförmige Friktionselement 10 über die Oberfläche des Aktuators an dessen Unterseite 4 herausragen. Darüber hinaus ist denkbar, dass ein Friktionselement 10 in Form eines Kugelabschnitts vorliegt, welches mit seiner flachen Seite an der Oberfläche des Aktuators 1 an dessen Oberseite 3 oder dessen Unterseite 4 angebracht ist, vorzugweise mittels eines Klebers.

Auf der Unterseite 4 des Aktuators 1 sind ebenfalls zwei Elektroden 8, 9 angeordnet, die in ihrer Form den Elektroden 6, 7 der Oberseite 3 im Wesentlichen entsprechen, die jedoch in etwa 90° zu diesen versetzt angeordnet sind. Auch hier sind die Elektroden 8, 9 durch einen im Wesentlichen linienförmigen, unelektrodierten Trennbereich 5 voneinander getrennt. Der Trennbereich 5 der Unterseite 4 ist hierbei im Wesentlichen senkrecht zum Trennbereich 5 der Oberseite 3 angeordnet. Die Elektroden 8, 9 erstrecken sich bis zu den entsprechenden Seitenflächen des Aktuators und schließen mit diesen ab. Genauso gut ist jedoch denkbar, dass die Elektroden zumindest abschnittsweise nicht ganz bis zu den Seitenflächen reichen, so dass ein entsprechender Bereich der Oberseite 4 zusätzlich zu dem Trennbereich 5 unelektrodiert ist

Zwischen Oberseite 3 und Unterseite 4 bzw. zwischen den Elektroden 6, 7 und den Elektroden 8, 9 befindet sich piezokeramisches Material.

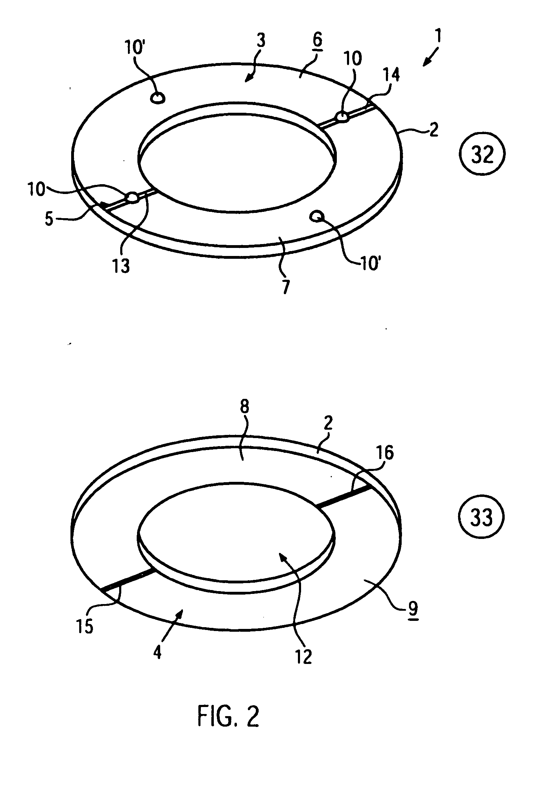

Figur 2 zeigt in schematischer Weise einen erfindungsgemäßen Aktuator 1 in Form einer ringförmigen, einschichtigen Platte. Die obere Darstellung 32 zeigt in perspektivischer Ansicht den Aktuator von oben, d.h. mit Blickrichtung auf dessen Oberseite 3, während die untere Darstellung 33 den Aktuator von unten zeigt, also mit Blickrichtung auf dessen Unterseite 4. Auf der Oberseite 3 sind zwei im Wesentlichen halbkreisförmige Elektroden 6 und 7 angeordnet, wobei sich zwischen den beiden Elektroden 6, 7 ein im Wesentlichen linienförmiger und unelektrodierter Trennbereich 5 befindet. Besagter linienförmiger Trennbereich 5 ist hierbei quasi durch die Aussparung 12 im Innenbereich des ringförmigen Aktuators unterbrochen, so dass sich zwei Trennbereichsabschnitte 13 und 14 ergeben. Diese Trennbereichsabschnitte 13 und 14 sind entlang einer durch den Mittelpunkt des ringförmigen Aktuators verlaufenden Linie angeordnet. Diese Linie ist gleichzeitig die Symmetrielinie, bezüglich derer die Elektroden 6 und 7 gespiegelt sind.

Die Elektroden 6, 7 erstrecken sich in radialer Richtung bis zu den Seitenflächen des Aktuators und schließen mit diesen ab. Ebenso ist jedoch denkbar, die Elektroden so zu gestalten, dass sie zumindest abschnittsweise von den Seitenflächen des Aktuators beabstandet sind. In Bezug auf die Längserstreckung der Trennbereichsabschnitte 13, 14 ist in deren Mitte jeweils ein Friktionselement 10 angeordnet, welches kugelförmig und in den Aktuator eingebettet ist, so dass nur Kugelabschnitt aus dem Aktuator an dessen Oberseite 3 herausragt. Zusätzlich zu besagten beiden gegenüberliegend angeordneten Friktionselementen 10 sind zwei weitere Friktionselemente 10' vorhanden, die ebenfalls gegenüberliegend angeordnet sind, jedoch um im Wesentlichen 90° versetzt zu den beiden zuvor erwähnten Friktionselementen 10. Die Friktionselemente 10' sind hierbei innerhalb des Bereiches der Elektroden 6 und 7 angeordnet.

Ebenso ist denkbar, dass die Friktionselemente 10 in Bezug auf die Längserstreckung der Trennbereichsabschnitte 13, 14 an deren Ende angeordnet sind, vorzugsweise am radial inneren Ende der Trennbereichsabschnitte.

Auf der Unterseite 4 des ringförmigen Aktuators 1 sind ebenfalls zwei Elektroden 8, 9 angeordnet, die in ihrer Form den Elektroden 6, 7 der Oberseite 3 entsprechen, die jedoch 90° zu diesen versetzt angeordnet sind. Auch hier sind die Elektroden 8, 9 durch einen im Wesentlichen linienförmigen, unelektrodierten Trennbereich 5 umfassend die zwei Trennbereichsabschnitte 15, 16 voneinander getrennt. Die Trennbereichsabschnitte 15 und 16 sind entlang einer durch den Mittelpunkt des Aktuators verlaufenden Linie angeordnet, die gleichzeitig die Symmetrielinie darstellt, bezüglich derer die Elektroden 8, 9 gespiegelt sind. Besagte Symmetrielinie, entlang derer die Trennbereichsabschnitte 15 und 16 angeordnet sind, schneidet die Symmetrielinie, entlang derer die Trennbereichabschnitt 13 und 14 angeordnet sind, in einem Winkel von im Wesentlichen 90°.

Es ist denkbar, dass die Friktionselemente 10' in Bezug auf die Längserstreckung der Trennbereichsabschnitte 15, 16 an deren Ende angeordnet sind, vorzugsweise am radial inneren Ende der Trennbereichsabschnitte.

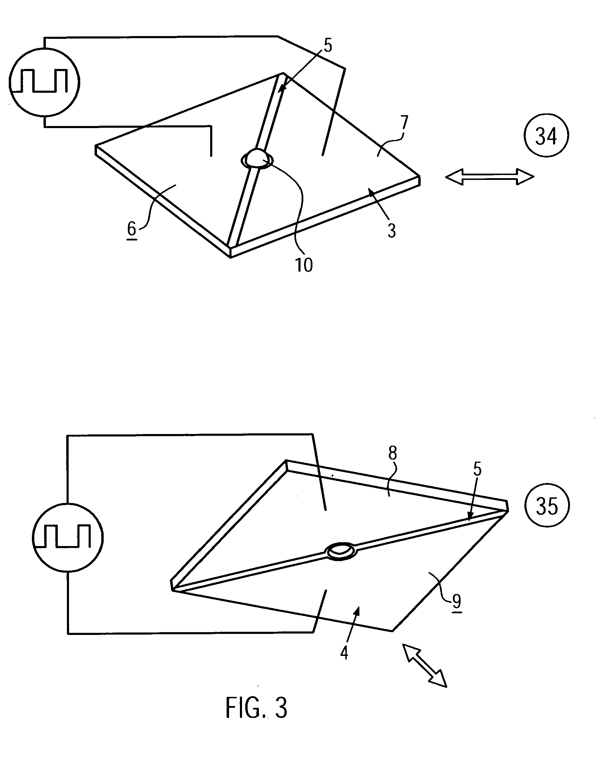

Fig. 3 zeigt in schematischer Weise die Darstellung der elektrischen Ansteuerung des quadratischen Aktuators gemäß Fig. 1 zur Realisierung einer zweiachsigen linearen Bewegung. Hierbei werden unabhängig voneinander die Elektroden 6, 7 der Oberseite 3 und die Elektroden 8, 9 der Unterseite 4 mit einer elektrischen Ansteuerspannung beaufschlagt. Gemäß der oberen Darstellung 34 von Fig. 3 erfolgt eine Ansteuerung der Elektroden 6, 7 mit einer Rechteckwelle, wobei die Elektroden 6, 7 gegenpolig angesteuert sind. Die Rechteckwelle besitzt hierbei vorzugsweise ein Tastverhältnis von 60 bis 80. Bei zuvor beschriebener elektrischer Ansteuerung der Elektroden 6 und 7 ergeben sich periodische Deformationen bzw. Schwingungen oder Vibrationen im Wesentlichen senkrecht zum linienförmigen Trennbereich 5 der Oberseite 3, die über das Friktionselement 10 auf ein anzutreibendes Element übertragbar sind, wodurch das anzutreibende Element in entsprechende Bewegung versetzt werden kann. In Analogie zu dem Vorstehenden erfolgt gemäß der unteren Darstellung 35 von Fig. 3 eine Ansteuerung der Elektroden 8 und 9 mit einer Rechteckwelle, wobei die Elektroden 8, 9 ebenfalls gegenpolig angesteuert sind. Die Rechteckwelle besitzt hierbei ebenso ein Tastverhältnis von 60 bis 80. Besagte elektrische Ansteuerung der Elektroden 8, 9 führt zu periodischen Deformationen bzw. Schwingungen oder Vibrationen im Wesentlichen senkrecht zum linienförmigen Trennbereich 5 der Unterseite 4, wobei die Schwingungen über das Friktionselement 10 auf ein anzutreibendes Element übertragbar sind, wodurch das anzutreibende Element in eine entsprechende Bewegung versetzt werden kann. Durch zeitlich voneinander getrenntes elektrisches Ansteuern der Elektroden 6, 7 der Oberseite 3 und der Elektroden 8, 9 der Unterseite 4 sind somit Deformationen bzw. Schwingungen in zwei unterschiedlichen Achsrichtungen des Aktuators möglich und damit auch eine entsprechende zweiachsige Bewegung eines durch den Aktuator anzutreibenden Elements. Unter zeitlichem Gesichtspunkt erfolgt zunächst die Ansteuerung der Elektroden 6, 7 und danach die Ansteuerung der Elektroden 8, 9 oder umgekehrt. Daraus folgen zeitlich gesehen zunächst Schwingungen entlang einer Achsrichtung, und sobald die entsprechende Bewegung eines mit dem Aktuator zu bewegenden Elements abgeschlossen ist folgen Schwingungen entlang der zweiten Achsrichtung, die das anzutreibende Element entlang der zweiten Achsrichtung antreiben.

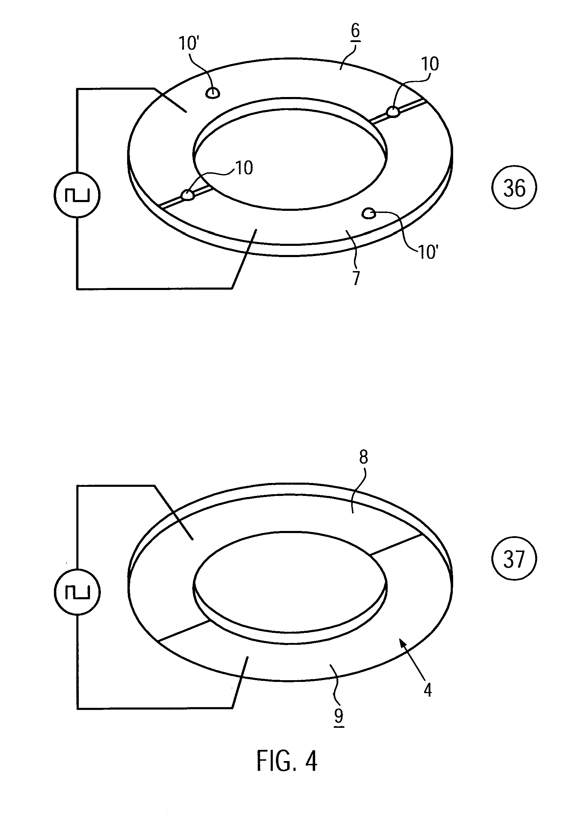

Fig. 4 zeigt in schematischer Weise die Darstellung der elektrischen Ansteuerung des ringförmigen Aktuators gemäß Fig. 2 zur Realisierung einer zweiachsigen linearen Bewegung. Hierbei zeigt die obere Darstellung 36 die Kontaktierung der Elektroden 6, 7 der Oberseite 3, während die untere Darstellung 37 die Kontaktierung der Elektroden 8 und 9 der Unterseite 4 zeigt. Da die elektrische Kontaktierung in identischer Weise wie in der Beschreibung zu Fig. 3 erfolgt, wird diese daher hier nicht weiter erläutert.

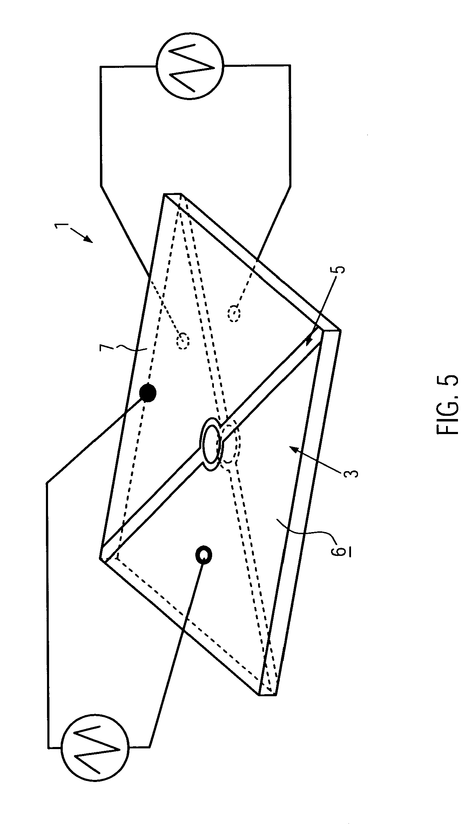

Fig. 5 zeigt in schematischer Weise die Darstellung der elektrischen Ansteuerung des quadratischen Aktuators gemäß Fig. 1 zur Realisierung einer rotatorischen Bewegung. Hierbei ist die Kontaktierung an sich identisch zu der in Fig. 3 gezeigten, während bei der (zeitlichen) elektrischen Ansteuerung der Unterschied besteht, dass die Elektroden 6, 7 der Oberseite 3 mit einem sinusförmigen Spannungssignal angesteuert werden, während die Elektroden 8, 9 der Unterseite 4 gleichzeitig mit einem co-sinusförmigen Spannungssignal angesteuert werden. Die Spannungssignale zum Ansteuern der Elektroden 6, 7 und 8, 9 sind identisch, weisen jedoch eine Phasendifferenz von 90° auf. Es findet somit eine definierte zeitliche Anpassung bezüglich der elektrischen Beaufschlagung der Elektroden 6, 7 und 8, 9 statt, so dass insgesamt eine Deformation des Aktuators resultiert, die einer Hula-Hoop-Bewegung gleicht. Der Mittenbereich des Aktuators - in dem normalerweise das Friktionselement angeordnet ist, was in Fig. 5 nicht dargestellt ist - beschreibt hierbei eine im Wesentlichen kreisförmige Bewegung. Ein im Mittenbereich des Aktuators angeordnetes Friktionselement ist daher in der Lage, ein anzutreibendes Element in eine rotatorische Bewegung zu versetzen.

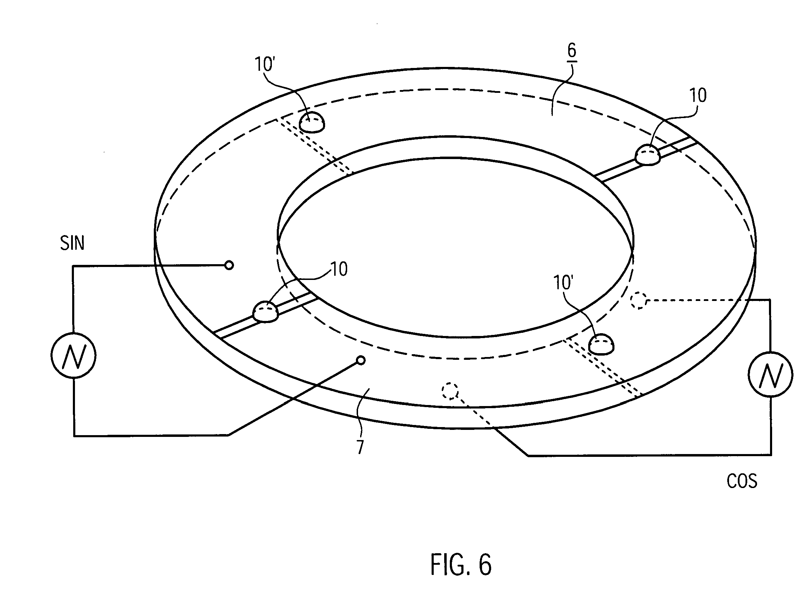

Fig. 6 zeigt in schematischer Weise die Darstellung der elektrischen Ansteuerung des ringförmigen Aktuators gemäß Fig. 2 zur Realisierung einer rotatorischen Bewegung. Da die Ansteuerung prinzipiell in gleicher Weise geschieht wie beim Aktuator gemäß Fig. 5, wird hier auf eine weitergehende Beschreibung verzichtet.

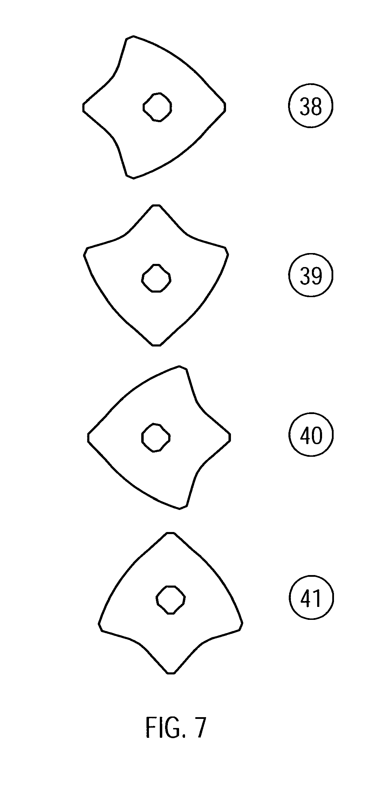

Fig. 7 zeigt in den Darstellungen 38 bis 41 Deformationen des quadratischen Aktuators nach Fig. 1 bei elektrischer Ansteuerung gemäß Fig. 5, die mit Hilfe der Finite-Elemente-Methode (FEM) berechnet wurden. Von oben nach unten bzw. ausgehend von Darstellung 38 bis zu Darstellung 41 sind vier unterschiedliche Deformationszustände zu unterschiedlichen, aufeinanderfolgenden Zeiten dargestellt. Hierbei bewegt sich der Mittelpunkt des Aktuators im Wesentlichen auf einer Kreisbahn, während die Deformationen des Aktuators im Bereich um den Mittelpunkt einer Hula-Hoop-Bewegung gleichen. Weiterhin ist Fig. 7 zu entnehmen, dass die Ecken des plattenförmigen Aktuators relativ große Deformationen bzw. Schwingungen vollführen. Daher ist es hier vorteilhaft, den Aktuator in eingebautem Zustand an seinen Seitenflächen, vorzugsweise in deren Mitte, zu unterstützen, da hier wesentlich geringere Deformationen auftreten. Hiermit ist eine Lagerung des Aktuators möglich, die einen besonders effizienten Betrieb des Aktuators erlaubt.

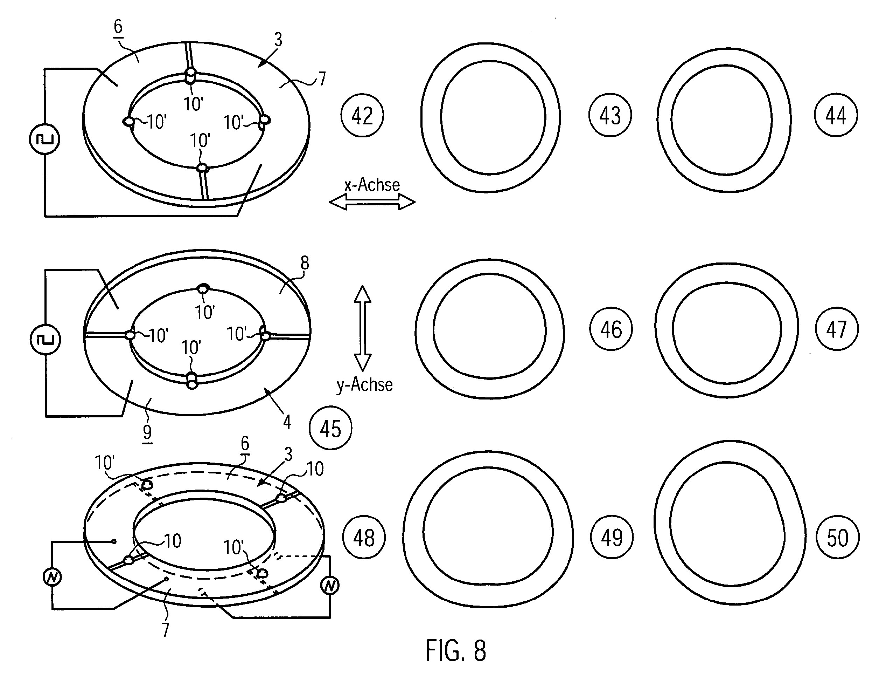

Fig. 8 zeigt in den Darstellungen 42 bis 50 Deformationen des ringförmigen Aktuators nach Fig. 2 bei elektrischer Ansteuerung gemäß Fig. 4 und Fig. 6, welche mit Hilfe der FEM berechnet wurden. Darstellung 42 wiederholt hierbei die bereits in Darstellung 36 von Fig. 4 gezeigte elektrische Kontaktierung zur Realisierung einer Deformations- bzw. Vibrationsbewegung in einer Achsrichtung. Anhand der Darstellungen 43 und 44, welche die mittels FEM berechnete Deformation des Aktuators zu zwei unterschiedlichen Zeitpunkten zeigen, ist zu sehen, dass der Aktuator im Wesentlichen Deformationen in Richtung der eingezeichneten x-Achse vollführt, und so in der Lage ist, ein mit diesem in Friktionskontakt stehendes anzutreibendes Element in entsprechende Bewegung zu versetzen.

In Darstellung 45 von Fig. 8 ist die bereits in Darstellung 37 von Fig. 4 gezeigte elektrische Kontaktierung zur Realisierung einer Deformations- bzw. Vibrationsbewegung in einer zweiten Achsrichtung wiederholt. Anhand der Darstellungen 46 und 47, welche die mittels FEM berechnete Deformation des Aktuators zu zwei unterschiedlichen Zeitpunkten zeigen, ist zu sehen, dass der Aktuator im Wesentlichen Deformationen in Richtung der eingezeichneten y-Achse vollführt, und so in der Lage ist, ein mit diesem in Friktionskontakt stehendes anzutreibendes Element in entsprechende Bewegung zu versetzen.

Darstellung 48 von Fig. 8 schließlich wiederholt die bereits in Fig. 6 gezeigte elektrische Ansteuerung eines ringförmigen Aktuators zur Realisierung einer rotatorischen Bewegung. Die Darstellungen 49 und 50 verdeutlichen die Deformationen des Aktuators zu zwei unterschiedlichen Zeitpunkten anhand von FEM-Berechnungen.

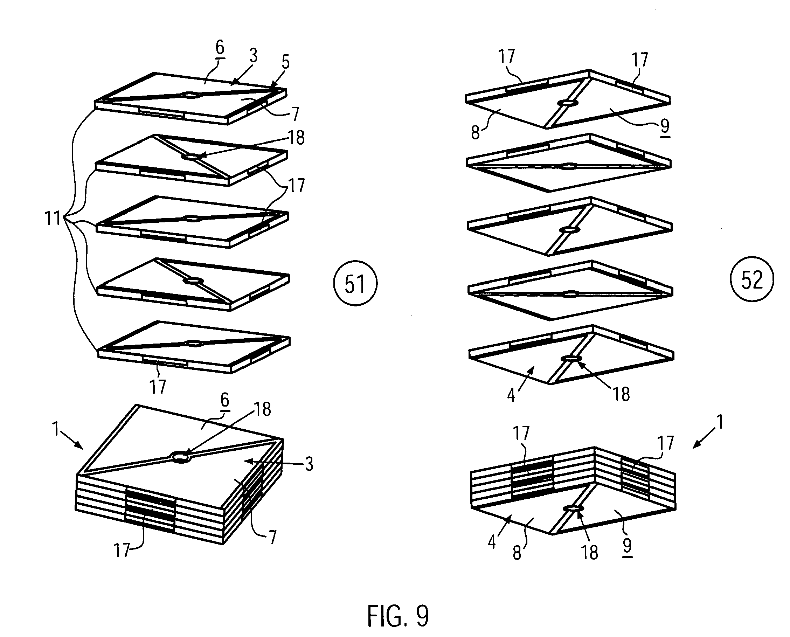

Fig. 9 zeigt in den Darstellungen 51 und 52 einen erfindungsgemäßen Aktuator in Form einer quadratischen Platte, wobei der Aktuator in mehreren Schichten 11 aufgebaut ist. Darstellung 51 zeigt die einzelnen Schichten 11 und den entsprechenden, daraus zusammengesetzten Aktuator 1 in perspektivischer Weise mit Blickrichtung auf die Oberseite/n des Aktuators 1 bzw. der Schichten 11, während Darstellung 52 die einzelnen Schichten und den entsprechenden, daraus zusammengesetzten Aktuator 1 in perspektivischer Weise mit Blickrichtung auf die Unterseite/n des Aktuators 1 bzw. der Schichten 11 zeigt. Der Aktuator 1 ist hierbei aus fünf einzelnen Schichten 11 aufgebaut, wobei jede Schicht einen Aufbau aufweist, der dem Aufbau des Aktuators als Ganzes entspricht. Somit besitzt jede Schicht auf ihrer Oberseite 3 und ihrer Unterseite 4 je zwei spiegelbildlich angeordnete, dreiecksförmige Elektroden 6, 7, 8 und 9, wobei die Elektroden 8, 9 der Unterseite 4 im Wesentlichen 90° versetzt zu den Elektroden 6, 7 der Oberseite 3 angeordnet sind. Angrenzende Schichten 11 sind jeweils 90° versetzt zueinander angeordnet. Die Kontaktierung der Elektroden 6, 7, 8, 9 auf den Ober- und Unterseiten geschieht über Seitenelektroden 17, die an den Seitenflächen der einzelnen Schichten 11 angeordnet sind.

Jede Schicht 11 besitzt in ihrem Flächenmittelpunkt ein Durchgangsloch 18, so dass auch der zusammengesetzte Aktuator ein Durchgangsloch 18 in dessen Mitte aufweist, in welches das hier nicht gezeigte Friktionselement, bevorzugt in Form einer Kugel, einsetzbar und vorzugsweise einklebbar ist.

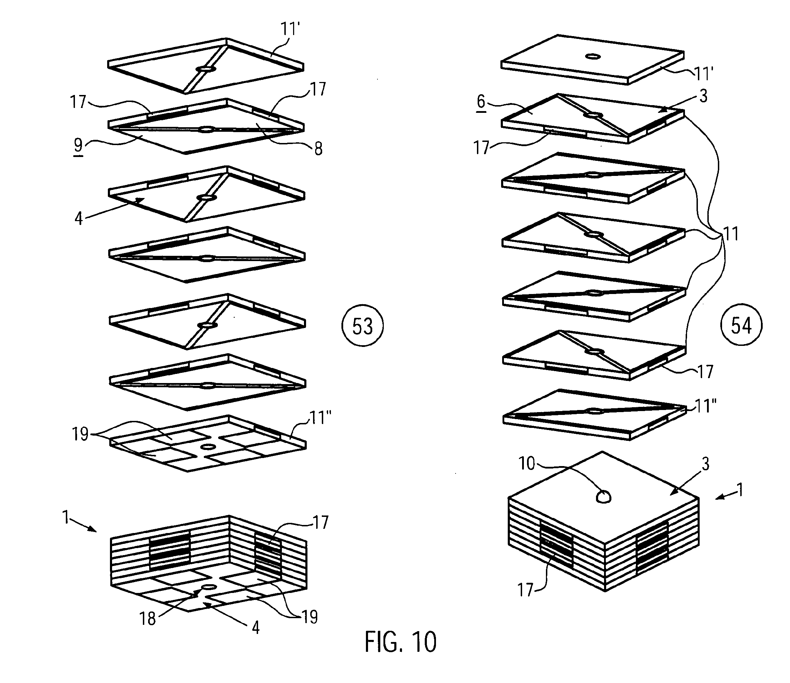

Fig. 10 zeigt in den Darstellungen 53 und 54 eine weitere mögliche Ausführungsform eines erfindungsgemäßen Aktuators in Form einer quadratischen Platte, der in mehreren Schichten aufgebaut ist. Während Darstellung 53 die einzelnen Schichten 11, 11', 11" und den entsprechenden, daraus zusammengesetzten Aktuator 1 in perspektivischer Weise mit Blickrichtung auf die Unterseite/n 4 des Aktuators bzw. der Schichten zeigt, zeigt Darstellung 54 die einzelnen Schichten 11, 11', 11" und den entsprechenden, daraus zusammengesetzten Aktuator 1 in perspektivischer Weise mit Blickrichtung auf die Oberseite/n 3 des Aktuators bzw. der Schichten. Der Aktuator 1 besteht aus insgesamt sieben Schichten, wobei die jeweils äußersten Schichten inaktive Schichten 11', 11" darstellen. Inaktiv bedeutet in diesem Zusammenhang, dass diese Schichten aufgrund entsprechender (fehlender) Elektrodierung nicht dazu vorgesehen sind, Deformationen auszuführen. Sie führen aktiv - also aufgrund elektrischer Anregung - keine Deformationen aus. Die in Darstellung 53 obere inaktive Schicht 11' weist keinerlei Elektroden auf, während die in Darstellung 53 untere inaktive Schicht 11" auf ihrer Unterseite 4 vier, jeweils 90° zueinander versetzte Terminationselektroden 19 aufweist, über welche die an den Seitenflächen der zwischen den inaktiven Schichten 11', 11" angeordneten Schichten 11 vorgesehenen Elektroden 17 mit einer entsprechenden elektrischen Ansteuerspannung versorgt werden können. Somit ist eine elektrische Kontaktierung von nur einer Seite des Aktuators 1, und hier im Speziellen von der Unterseite 4, möglich, was insbesondere für eine automatisierte Fertigung von Vorteil ist. Selbstverständlich ist es auch möglich, nur die obere inaktive Schicht 11' mit Terminationselektroden 19 zu versehen. Ebenso können sowohl die obere inaktive Schicht 11', als auch die untere inaktive Schicht 11" mit Terminationselektroden versehen sein.

Die Schichten 11, die zwischen den inaktiven Schichten 11', 11" angeordnet sind, weisen jeweils an ihrer Oberseite 3 und ihrer Unterseite 4 zwei spiegelbildlich angeordnete, dreiecksförmige Elektroden 6, 7, 8, 9 auf, wobei die Elektroden 6, 7 der Oberseite 3 90° versetzt zu den Elektroden 8, 9 der Unterseite 4 angeordnet sind. Alle Schichten 11, 11', 11" weisen in ihrer Mitte ein Durchgangsloch18 bzw. eine Durchgangsbohrung auf, so dass der zusammengesetzte Aktuator 1 in entsprechender Weise ein Durchgangsloch 18 aufweist, in das beispielsweise ein kugelförmiges Friktionselement einsetzbar ist. Darstellung 54 von Fig. 10 zeigt in nicht maßstabsgetreuer Weise ein in das Durchgangsloch 18 eingesetztes kugelförmiges Friktionselement 10, das bis zur Unterseite 4 des Aktuators 1 reicht und mit dieser abschließt.

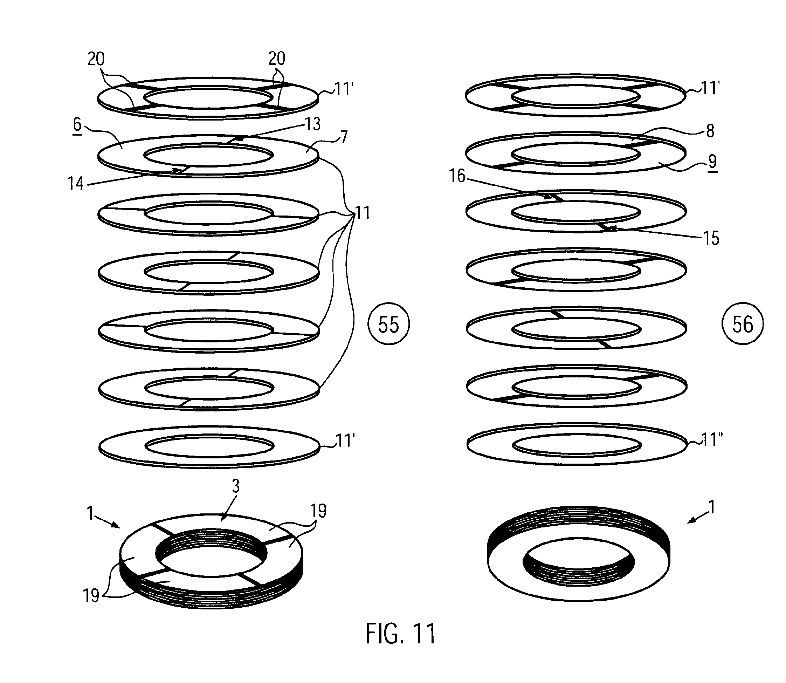

Fig. 11 zeigt in den Darstellungen 55 und 56 einen erfindungsgemäßen Aktuator in Form einer ringförmigen Platte, wobei der Aktuator in mehreren Schichten 11, 11', 11" aufgebaut ist. Während Darstellung 55 die einzelnen Schichten 11, 11', 11" und den entsprechenden, daraus zusammengesetzten Aktuator 1 in perspektivischer Weise mit Blickrichtung auf die Oberseite/n 3 des Aktuators 1 bzw. der Schichten 11, 11', 11" zeigt, zeigt Darstellung 56 die einzelnen Schichten 11, 11', 11" und den entsprechenden, daraus zusammengesetzten Aktuator 1 in perspektivischer Weise mit Blickrichtung auf die Unterseite/n 4 des Aktuators 1 bzw. der Schichten 11, 11', 11". Insgesamt weist der Aktuator sieben Schichten auf, wovon die oberste und die unterste Schicht jeweils inaktive Schichten 11', 11" sind. Die fünf zwischen den inaktiven Schichten 11', 11" angeordneten Schichten 11 weisen an ihrer Oberseite 3 jeweils zwei im Wesentlichen halbkreisförmige und durch die Trennbereichsabschnitte 13, 14 voneinander getrennte Elektroden 6, 7 auf. An der Unterseite 4 der zwischen den inaktiven Schichten 11', 11" angeordneten Schichten 11 befinden sich ebenso jeweils zwei im Wesentlichen halbkreisförmige und durch die Trennbereichsabschnitte 15, 16 voneinander getrennte Elektroden 8, 9, die gegenüber den Elektroden 6, 7 der Oberseite 3 um etwa 90° versetzt angeordnet sind. Die sich jeweils gegenüberliegenden Elektroden benachbarter Schichten 11 weisen die gleiche Orientierung auf.

Die obere inaktive Schicht 11' weist an ihrer Oberseite 3 vier Terminationselektroden 19 auf, die jeweils im Wesentlichen die Form eines Viertelkreises aufweisen und wovon jeweils zwei benachbarte Elektroden durch Isolationsabschnitte 20 voneinander getrennt bzw. isoliert sind. Die untere inaktive Schicht 11" weist hingegen keinerlei Elektroden auf. Über die Terminationselektroden können die an den Seitenflächen der zwischen den inaktiven Schichten angeordneten Schichten vorgesehenen Elektroden - die in den Darstellungen 55 und 56 der Fig. 11 nicht abgebildet sind - mit einer entsprechenden elektrischen Ansteuerspannung versorgt werden können. Somit ist eine elektrische Kontaktierung von nur einer Seite des Aktuators, und hier im Speziellen von der Oberseite, möglich, was insbesondere für eine automatisierte Fertigung von Vorteil ist. Genauso gut ist es natürlich möglich, nur die untere inaktive Schicht 11" mit Terminationselektroden 19 zu versehen. Auch das Vorsehen von Terminationselektroden an der oberen inaktiven Schicht 11' und an der unteren inaktiven Schicht 11" ist denkbar.

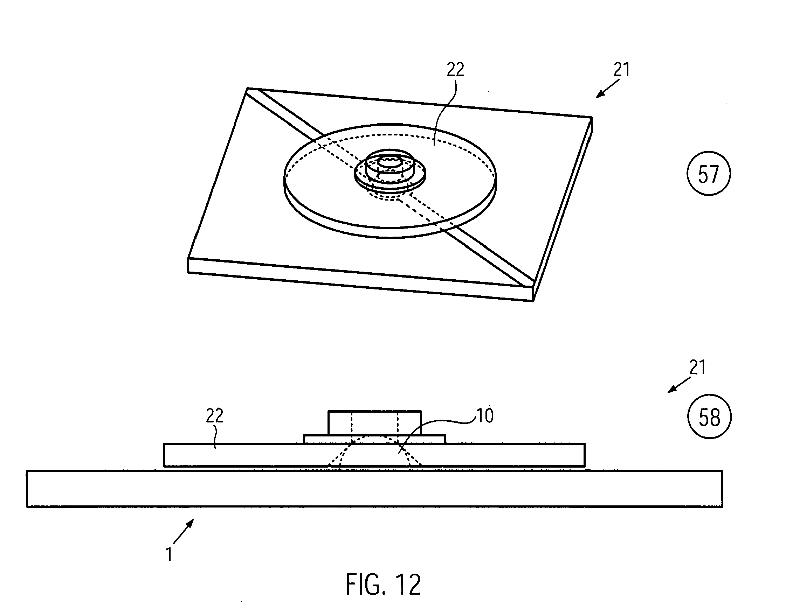

Fig. 12 zeigt in den Darstellungen 57 und 58 einen Motor 21 mit dem erfindungsgemäßen Aktuator 1 gemäß Fig. 1. Es handelt sich hierbei um einen Rotationsmotor, wobei der Aktuator 1 gemäß der Darstellung in Fig. 5 so elektrisch angesteuert wird, dass sein im Zentrum angeordnetes Friktionselement 10 eine kreisförmige Bewegung vollführt. Diese kreisförmige Bewegung überträgt sich auf den Rotor 22, mit dem sich das Friktionselement 10 in Friktionskontakt befindet. In diesem Fall fungiert der Aktuator 1 als Stator, und das über das Friktionselement 10 zu bewegende Element als Rotor 22.

## Patentansprüche

1. Aktuator (1), aufweisend piezoelektrisches Material, in Form einer einschichtigen oder mehrschichtigen flachen Platte (2), bei welchem zumindest eine Schicht sowohl auf deren Oberseite (3) als auch auf deren Unterseite (4) jeweils zwei voneinander durch einen im Wesentlichen linienförmigen Trennbereich (5) beabstandete Elektroden (6, 7, 8, 9) in gegenüberliegender Anordnung aufweist, und die Elektroden (6, 7) der Oberseite (3) versetzt zu den Elektroden (8, 9) der Unterseite (4) angeordnet sind, **dadurch gekennzeichnet, dass** der Aktuator (1) wenigstens ein Friktionselement (10) aufweist, wobei das Friktionselement (10) entlang des linienförmigen Trennbereichs (5) angeordnet ist.

2. Aktuator nach Anspruch 1, **dadurch gekennzeichnet, dass** der Aktuator (1) die Form einer polygonalen Platte, vorzugsweise einer quadratischen Platte aufweist.

3. Aktuator nach Anspruch 1 oder 2, **dadurch gekennzeichnet, dass** die Elektroden (6, 7) der Oberseite (3) um im Wesentlichen 90° versetzt zu den Elektroden (8, 9) der Unterseite (4) angeordnet sind.

4. Aktuator nach einem der vorangegangenen Ansprüche, **dadurch gekennzeichnet, dass** das Friktionselement (10) entlang des linienförmigen Trennbereichs (5) in dessen Mitte oder an einem Ende davon angeordnet ist.

5. Aktuator nach Anspruch 4, **dadurch gekennzeichnet, dass** das Friktionselement (10) in den Aktuator (1), vorzugsweise in ein in dem Aktuator vorgesehenes Durchgangsloch, eingesetzt ist.

6. Aktuator nach einem der vorangegangenen Ansprüche, **dadurch gekennzeichnet, dass** der Aktuator (1) mehrschichtig aufgebaut ist und eine ungerade Anzahl von Schichten (11) aufweist, wobei die sich jeweils zugewandten Elektroden (6, 7, 8, 9) angrenzender Schichten die gleiche Orientierung aufweisen.

7. Aktuator nach Anspruch 6, **dadurch gekennzeichnet, dass** die oberste Schicht und die unterste Schicht des Aktuators (1) inaktive Schichten (11', 11 ")sind.

8. Aktuator nach Anspruch 7, **dadurch gekennzeichnet, dass** die oberste Schicht und/oder die unterste, inaktive Schicht (11', 11 ") mit Terminationselektroden (19) versehen sind/ist.

9. Aktuator nach einem der vorangegangenen Ansprüche, **dadurch gekennzeichnet, dass** der Aktuator (1) unter Anregung der zweiten Resonanzfrequenz oder einem ganzzahligen Vielfachen der zweiten longitudinalen Resonanzfrequenz betrieben wird.

10. Aktuator nach einem der vorangegangenen Ansprüche, **dadurch gekennzeichnet, dass** durch elektrisches Ansteuern der Elektroden (6, 7) der Oberseite (3) schwingende Deformationen des Aktuators (1) entlang einer ersten Achsrichtung erzielbar sind, die zum Antrieb eines mit dem Aktuator in Kontakt stehenden beweglichen Elements in der ersten Achsrichtung nutzbar sind.

11. Aktuator nach einem der vorangegangenen Ansprüche, **dadurch gekennzeichnet, dass** durch elektrisches Ansteuern der Elektroden (8, 9) der Unterseite (4) schwingende Deformationen des Aktuators (1) entlang einer zweiten Achsrichtung erzielbar sind, die zum Antrieb eines mit dem Aktuator in Kontakt stehenden beweglichen Elements in der zweiten Achsrichtung nutzbar sind.

12. Aktuator nach einem der vorangegangen Ansprüche, **dadurch gekennzeichnet, dass** durch phasenverschobenes elektrisches Ansteuern der Elektroden (6, 7) der Oberseite (3) und der Elektroden (8, 9) der Unterseite (4) Hula-Hoop-artige Deformationen erzielbar sind, die zum rotatorischen Antrieb
eines mit dem Aktuator in Kontakt stehenden beweglichen Elements nutzbar sind.

13. Aktuator nach einem der vorangegangenen Ansprüche, **dadurch gekennzeichnet, dass** die durch das elektrische Ansteuern der Elektroden (6, 7, 8, 9) erzielten Deformationen in der Ebene des Aktuators (1) liegen.

14. Motor, umfassend den Aktuator nach einem der vorangegangenen Ansprüche und ein durch den Aktuator anzutreibendes bewegliches Element.

## Claims

1. Actuator (1), having piezoelectric material, in the form of a single-layer or multi-layer flat plate (2), wherein at least one layer has two electrodes (6, 7, 8, 9) spaced from each other by means of an essentially linear separating area (5) and arranged opposite each other both on its upper face (3) and on its lower face (4), and said electrodes (6, 7) of said upper face (3) are arranged at an offset from said electrodes (8, 9) of said lower face (4), **characterized in that** said actuator (1) comprises at least one friction element (10), wherein said friction element (10) is arranged along said linear separating area (5).

2. Actuator according to claim 1, **characterized in that** said actuator (1) has the shape of a polygonal plate, preferably of a square plate.

3. Actuator according to claims 1 or 2, **characterized in that** said electrodes (6, 7) of said upper face (3) are arranged at an offset from said electrodes (8, 9) of said lower face (4) by essentially 90°.

4. Actuator according to one of the preceding claims, **characterized in that** said friction element (10) is arranged at its center or at one end thereof.

5. Actuator according to claim 4, **characterized in that** said friction element (10) is inserted into said actuator (1), preferably into a through-hole provided in said actuator.

6. Actuator according to one of the preceding claims, **characterized in that** said actuator (1) has a multilayer structure and an odd number of layers (11), wherein said respective electrodes (6, 7, 8, 9) facing each other on adjacent layers have the same orientation.

7. Actuator according to claim 6, **characterized in that** the uppermost layer and lowermost layer of said actuator (1) are inactive layers (11', 11").

8. Actuator according to claim 7, **characterized in that** said uppermost layer and / or said lowermost inactive layer (11', 11") are / is provided with termination electrodes (19).

9. Actuator according to one of the preceding claims, **characterized in that** said actuator (1) is operated while exciting the second resonant frequency or an integral multiple of the second longitudinal resonance frequency.

10. Actuator according to one of the preceding claims, **characterized in that**, by electrically actuating said electrodes (6, 7) of said upper face (3), oscillating deformations of said actuator (1) along a first axial direction are achievable, which can be used for driving a movable element being in contact with said actuator in said first axial direction.

11. Actuator according to one of the preceding claims, **characterized in that**, by electrically actuating said electrodes (8, 9) of said lower face (4), oscillating deformations of said actuator (1) along a second axial direction are achievable, which can be used for driving a movable element being in contact with said actuator in said second axial direction.

12. Actuator according to one of the preceding claims, **characterized in that**, by electrically actuating said electrodes (6, 7) of said upper face (3) and said electrodes (8, 9) of said lower face (4), hula-hoop-like deformations are achievable, which can be used for rotationally driving a movable element being in contact with said actuator.

13. Actuator according to one of the preceding claims, **characterized in that**, said deformations obtained by electrical actuation of said electrodes (6, 7, 8, 9) are located in the plane of said actuator (1).

14. Motor, comprising said actuator according to one of the preceding claims and an element to be driven by said actuator.

## Revendications

1. Actionneur (1) présentant du matériau piézoélectrique, sous la forme d'une plaque (2) plane, monocouche ou multicouches, dans lequel au moins une couche présente aussi bien sur sa face supérieure (3) que sur sa face inférieure (4), respectivement deux électrodes (6, 7, 8, 9), qui sont espacées l'une de l'autre par une zone de séparation (5) sensiblement en forme de ligne et sont disposées selon un agencement en opposition, et les électrodes (6, 7) de la face supérieure (3) étant agencées de manière décalée par rapport aux électrodes (8, 9) de la face inférieure (4), **caractérisé en ce que** l'actionneur (1) comprend au moins un élément de friction (10), l'élément de friction (10) étant agencé le long de ladite zone de séparation (5) en forme de ligne.

2. Actionneur selon la revendication 1, **caractérisé en ce que** l'actionneur (1) présente une forme de plaque polygonale, de préférence d'une plaque carrée.

3. Actionneur selon la revendication 1 ou la revendication 2, **caractérisé en ce que** les électrodes (6, 7) de la face supérieure (3) sont agencées de manière sensiblement décalée de 90° par rapport aux électrodes (8, 9) de la face inférieure (4).

4. Actionneur selon l'une des revendications précédentes, **caractérisé en ce que** l'élément de friction (10) est agencé le long de la zone de séparation (5) en forme de ligne, en son milieu ou à une extrémité de celle-ci.

5. Actionneur selon la revendication 4, **caractérisé en ce que** l'élément de friction (10) est inséré dans l'actionneur (1), de préférence dans un trou de passage prévu dans l'actionneur.

6. Actionneur selon l'une des revendications précédentes, **caractérisé en ce que** l'actionneur (1) est d'une construction multicouches et présente un nombre pair de couches (11), les électrodes (6, 7, 8, 9) respectivement dirigées l'une vers l'autre, de couches voisines, présentant la même orientation.

7. Actionneur selon la revendication 6, **caractérisé en ce que** la couche supérieure et la couche inférieure de l'actionneur (1) sont des couches inactives (11', 1").

8. Actionneur selon la revendication 7, **caractérisé en ce que** la couche inactive (11', 11") supérieure et/ou inférieure est/sont munie(s) d'électrodes de terminaison (19).

9. Actionneur selon l'une des revendications précédentes, **caractérisé en ce que** l'on fait fonctionner l'actionneur (1) par excitation de la deuxième fréquence de résonance ou d'un multiple entier de la deuxième fréquence de résonance longitudinale.

10. Actionneur selon l'une des revendications précédentes, **caractérisé en ce que** par commande électrique des électrodes (6, 7) de la face supérieure (3), il est possible d'obtenir des déformations oscillatoires de l'actionneur (1) le long d'une première direction d'axe, qui peuvent être utilisées pour l'entraînement, dans la première direction d'axe, d'un élément mobile en contact avec l'actionneur.

11. Actionneur selon l'une des revendications précédentes, **caractérisé en ce que** par commande électrique des électrodes (8, 9) de la face inférieure (4), il est possible d'obtenir des déformations oscillatoires de l'actionneur (1) le long d'une deuxième direction d'axe, qui peuvent être utilisées pour l'entraînement, dans la deuxième direction d'axe, d'un élément mobile en contact avec l'actionneur.

12. Actionneur selon l'une des revendications précédentes, **caractérisé en ce que** par une commande électrique déphasée des électrodes (6, 7) de la face supérieure (3) et des électrodes (8, 9) de la face inférieure (4), il est possible d'obtenir des déformations à la manière d'un cerceau dit Hula-Hoop, qui peuvent être utilisées pour l'entraînement rotatif d'un élément mobile en contact avec l'actionneur.

13. Actionneur selon l'une des revendications précédentes, **caractérisé en ce que** les déformations obtenues par la commande électrique des électrodes (6, 7, 8, 9) se situent dans le plan de l'actionneur (1).

14. Moteur comprenant un actionneur selon l'une des revendications précédentes et un élément mobile à entraîner par l'actionneur.
